# EUROPÄISCHE PATENTSCHRIFT

(11) **EP 1 610 452 B1**
(45) Veröffentlichungstag und Bekanntmachung des Hinweises auf die Patenterteilung: **28.12.2011**
(21) Anmeldenummer: 05005702.5
(22) Anmeldetag: 16.03.2005
(51) Int. Cl.: H02M 7/00, H05K 7/20

(54) **Wechselrichter mit einem Gehäuse mit Kühlkörper aufweisenden elektrischen und/oder elektronischen Komponenten**
Inverter witn a casing with electric and/or electronic components having cooling bodies
Onduleur avec un boîtier avec des composants électriques et/ou électroniques comportants des corps de refroidissement

(30) Priorität: 24.06.2004 DE 202004009926 U; 24.06.2004 DE 102004030457
(43) Veröffentlichungstag der Anmeldung: 28.12.2005
(73) Patentinhaber: SMA Solar Technology AG, 34266 Niestetal (DE)
(72) Erfinder: Cramer, Günther, 34128 Kassel (DE)
(74) Vertreter: Walther, Walther & Hinz GbR

(56) Entgegenhaltungen:
- EP-A- 0 900 621
- DE-U1- 20 016 013

## Beschreibung

Die vorliegende Erfindung betrifft einen Wechselrichter mit einem Gehäuse, mit Kühlkörper aufweisenden elektrischen und/oder elektronischen Komponenten, mit mindestens einer Drossel und/oder einem Trafo, die selbst eine hohe Schutzart aufweisen und mit einem Kühlaggregat zur Kühlung der elektrischen und/oder elektronischen Komponenten.

Aus der EP 900 621 A1 ist eine Stromversorgungseinheit mit zwei Räumen bekannt, wobei sämtliche Wärme entwickelnden Bauteile in lediglich dem einen Raum angeordnet sind, wobei diese Bauteile auf einem Kühlkörper angeordnet sind, der die Wand zu einem Kühlraum bildet. Der Kühlkörper weist auf der dem Kühlraum zugewandten Seite Kühlrippen auf, die durch ein Gebläse gekühlt werden, wobei die Kühlluft aus der Umgebung gezogen wird.

Das DE 200 16 013 U1 zeigt einen Schaltschrank, der durch eine Montageplatte in zwei Kammern unterteilt ist. In der einen Kammer, der Bauteilkammer, sind die Wärme erzeugenden Bauteile untergebracht, die mit einem Kühlkörper in Verbindung stehen, der sich in einer Kühlluftkammer befindet. Mittels eines Gebläses wird dafür gesorgt, dass die vom Kühlkörper erzeugte Warmluft durch die offene Rückseite des Schaltschrankes an die Umgebung abgeführt wird.

-Ein Wechselrichter umfasst ein Gehäuse, das der Aufnahme der elektrischen und/oder elektronischen Komponenten dient. Ein solches Wechselrichtergehäuse besitzt häufig eine Lüftung, insbesondere in Form eines elektrischen Lüfters, wobei durch Zuführung von Außenluft in das Gehäuse die elektrischen bzw. elektronischen Komponenten gekühlt werden. Da Wechselrichter nicht nur in Gebäuden angebracht sind, sondern auch außerhalb von Gebäuden, werden durch den Lüfter nicht nur Luft, sondern auch Schmutz, Staub und Feuchtigkeit in das Gehäuse eingeblasen. So ist bereits nach kurzer Zeit festzustellen, dass die elektrischen und/oder elektronischen Komponenten im Inneren des Gehäuses des Wechselrichters stark verschmutzt sind. Die Verschmutzung bewirkt die bekannten Ausfälle. Auch der Einsatz von vor dem Lüfter angeordneten Filtern ist insofern problematisch, als dann, wenn sich der Filter zugesetzt hat, die Kühlleistung sehr eingeschränkt ist.

Der Erfindung liegt daher die Aufgabe zu Grunde, einen Wechselrichter der eingangs genannten Art bereitzustellen, bei dem auch unter ungünstigen äußeren Bedingungen die Kühlleistung über einen langen Zeitraum im Wesentlichen uneingeschränkt zur Verfügung steht.

Die Aufgabe wird erfindungsgemäß durch die Merkmale des kennzeichnenden Teils des Anspruches 1 in Verbindung mit den Merkmalen des Oberbegriffs gelöst. Bevorzugt befindet sich hierbei die mindestens eine Drossel und/oder der Trafo an der Wandseite der Wand der anderen Kammer. Das Gehäuse des Wechselrichters weist mindestens zwei Kammern auf, wobei die beiden Kammern durch eine Wand zur Aufnahme der verlustbehafteten Komponenten getrennt sind, wobei dann, wenn diese Komponenten Kühlkörper aufweisen, sich die Komponenten auf der einen Seite der Wand in der einen Kammer und die Kühlkörper auf der anderen Seite der Wand in der anderen Kammer befinden und wobei dann, wenn die zu kühlende Komponente, z. B. ein Transformator, eine hohe Schutzart aufweist, sich diese Komponente an der Wandseite in der anderen Kammer befindet, wobei die andere Kammer das Kühlaggregat aufweist, also gekühlt wird. Das heißt, gekühlt wird nur die Kammer des Wechselrichtergehäuses, in der sich die Kühlkörper oder zu kühlende Komponenten hoher Schutzart befinden. Bekanntermaßen sind die Kühlkörper oder auch Wärmetauscher sehr unempfindlich gegenüber Schmutz und Feuchtigkeit, zumindest aber wesentlich unempfindlicher als die elektrischen und/oder elektronischen Komponenten des Wechselrichters, die nicht besonders geschützt sind. Insofern können die Kühlkörper und die Komponenten hoher Schutzart unmittelbar im Kühlstrom liegen, wobei die Verschmutzung der Kühlkörper, und die Verschmutzung von Komponenten hoher Schutzart (z. B. IP65) selbst nur geringe Auswirkungen auf die Kühlleistung hat. Gegebenenfalls kann allerdings vor das Kühlaggregat, beispielsweise einen Lüfter, ein entsprechendes Filter nach- oder vorgeschaltet werden.

Weitere vorteilhafte Merkmale sind den Unteransprüchen zu entnehmen. So ist insbesondere vorgesehen, dass die andere Kammer Lüftungsschlitze aufweist, wobei die Lüftungsschlitze vorteilhaft am entgegengesetzten Ende zum Kühlaggregat in der anderen Kammer angeordnet sind, um die Kammer von einem Ende zum anderen Ende mit Kühlluft durchströmen zu lassen.

Weiterhin weist vorteilhaft die eine Kammer eine höhere Schutzart auf als die andere Kammer, d. h., dass die eine Kammer, die die elektronischen und/oder elektrischen Komponenten aufweist, insbesondere auch staubdicht und spritzwassergeschützt ist, wohingegen die andere Kammer gut zu durchlüften ist, mithin nur eingeschränkt gegen Staub und Feuchtigkeit geschützt werden muss.

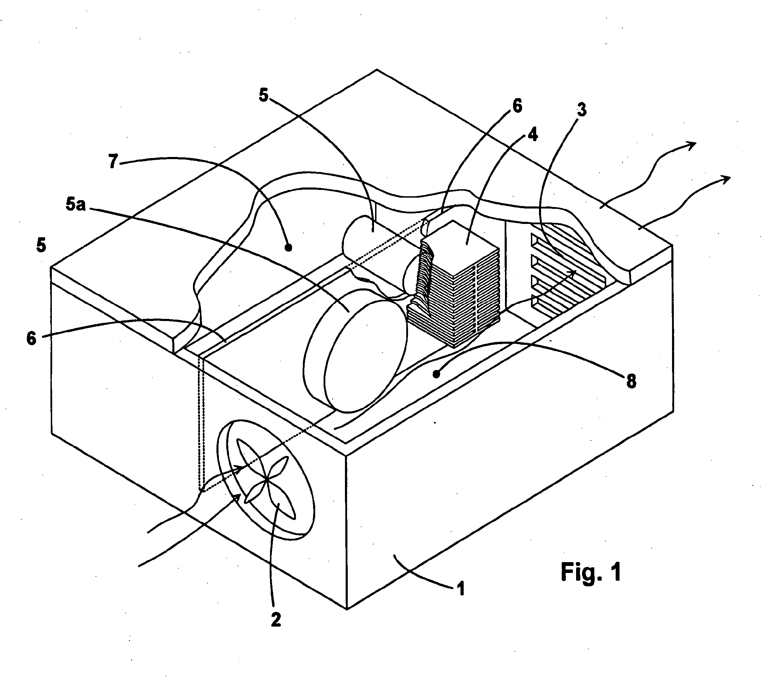

Anhand der Zeichnung wird die Erfindung nachstehend beispielhaft näher erläutert.

Der Wechselrichter besitzt das Gehäuse 1 mit der mittig im Gehäuse angeordneten Trennwand 6, die das Gehäuse in zwei Kammern 7 und 8 unterteilt. Die Trennwand 6 selbst nimmt die verlustbehafteten elektronischen und elektrischen Komponenten 5 auf. Hierbei ragen die Komponenten 5 selbst in die Kammer 7 hinein; die an den Komponenten 5 angeordneten Kühlkörper 4 in Form von Wärmetauschern hingegen befinden sich auf der gegenüberliegenden Seite dieser Trennwand 6 und ragen mithin in die andere Kammer 8 hinein. Das bedeutet, dass die elektrischen und/oder elektronischen Komponenten durch die Trennwand 6 mit ihren Kühlkörpern verbunden sind. Das heißt, zwischen Kühlkörper 4 und Komponente 5 ist eine thermische Verbindung vorgesehen, um die Wärme von der Komponente zum Kühlkörper führen zu können.

Andere verlustbehaftete Komponenten 5a, wie z. B. ein Transformator hoher Schutzart können unmittelbar in der anderen gekühlten Kammer 8 angeordnet sein, da durch die hohe Schutzart diese unempfindlich gegenüber Verschmutzung sind.

Diese andere Kammer 8 weist einen Lüfter 10 und entsprechende Lüftungsschlitze 3 auf, die in der Kammer 8 des Gehäuses am entgegengesetzten Ende zum Lüfter im Gehäuse angeordnet sind. Wesentlich hierbei ist, dass die eine Kammer eine höhere Schutzart aufweist als die andere Kammer, um sicherzustellen, dass die elektrischen oder elektronischen Komponenten vor Verschmutzung und Feuchtigkeit geschützt sind. Dies gilt bis auf die Komponenten, die selbst eine hohe Schutzart aufweisen, z. B. vergossene Wickelgüter wie Transformatoren oder Drosseln, die unmittelbar in der anderen Kammer 8 angeordnet sind. Andere elektrische und elektronische Bauteile, die keine oder nur eine geringe Verlustleistung produzieren, sind in der einen, nicht gekühlten Kammer 7 untergebracht, und zwar an beliebiger Stelle der Kammer 7, also nicht unbedingt an der Wand 6.

## Patentansprüche

1. Wechselrichter mit einem Gehäuse (1), mit Kühlkörper (4) aufweisenden elektrischen und/oder elektronischen Komponenten (5), mit mindestens einer Drossel und/oder einem Trafo (5a), die selbst eine hohe Schutzart aufweisen und mit einem Kühlaggregat (2) zur Kühlung der elektrischen und/oder elektronischen Komponenten (5),
**dadurch gekennzeichnet,**
**dass** das Gehäuse (1) mindestens zwei Kammern (7, 8) aufweist, wobei die beiden Kammern (7, 8) durch eine Wand (6) getrennt sind, wobei sich die Komponenten (5) auf der einen Seite der Wand in der einen Kammer (7) befinden und die Kühlkörper (4) auf der anderen Seite der Wand (6) in der anderen Kammer (8) befinden, und wobei sich die mindestens eine Drossel und/oder der Trafo (5a) in der anderen Kammer (8) befinden, wobei die andere Kammer (8) das Kühlaggregat (2) aufweist.

2. Wechselrichter nach Anspruch 1,
**dadurch gekennzeichnet,**
**dass** die andere Kammer (8) Lüftungsschlitze (3) aufweist.

3. Wechselrichter nach Anspruch 2,
**dadurch gekennzeichnet,**
**dass** die Lüftungsschlitze (3) am entgegengesetzten Ende zum Kühlaggregat (2) in der anderen Kammer (8) angeordnet sind.

4. Wechselrichter nach einem der voranstehenden Ansprüche,
**dadurch gekennzeichnet,**
**dass** die eine Kammer (7) eine höhere Schutzart aufweist als die andere Kammer (8).

5. Wechselrichter nach einem der voranstehenden Ansprüche,
**dadurch gekennzeichnet,**
**dass** das Kühlaggregat (2) als ein Lüfter ausgebildet ist.

6. Wechselrichter nach Anspruch 1,
**dadurch gekennzeichnet,**
**dass** sich die mindestens eine Drossel und/oder der Trafo (5a) an der Wandseite der Wand (6) der anderen Kammer (8) befinden.

## Claims

1. An inverter with a casing (1), with electric and/or electronic components (5) having cooling bodies (4), with at least one choke and/or a transformer (5a) comprising a high grade rating for protection, and with a cooling unit (2) for cooling the electric and/or electronic components (5),
**characterized in that**
the casing (1) comprises at least two chambers (7, 8), the two chambers (7, 8) being separated by a wall (6), the components (5) being located on one side of the wall in one of the chambers (7), the cooling bodies (4) being located on the other side of the wall (6) in the other chamber (8), and the at least one choke and/or transformer (5a) being located in the other chamber (8), wherein the other chamber (8) comprises the cooling unit (2).

2. The inverter according to claim 1,
**characterized in that**
the other chamber (8) comprises ventilation slots (3).

3. The inverter according to claim 2,
**characterized in that**
the ventilation slots (3) are disposed in the other chamber (8) at an end opposite to the cooling unit (2).

4. The inverter according to one of the preceding claims,
**characterized in that**
the one of the chambers (7) comprises a higher grade rating for protection than the other chamber (8).

5. The inverter according to one of the preceding claims,
**characterized in that**
the cooling unit (2) is configured as a ventilator.

6. The inverter according to claim 1,
**characterized in that**
the at least one choke and/or the transformer (5a) are located on the wall side of the wall (6) of the other chamber (8).

## Revendications

1. Onduleur comprenant un boîtier (1), des composants électriques et/ou électroniques (5) qui comportent des radiateurs (4), au moins une réactance et/ou un transformateur (5a) qui présentent eux-mêmes un haut degré de protection, et un groupe de refroidissement (2) agencé pour refroidir les composants électriques et/ou électroniques (5),
**caractérisé en ce que**
le boîtier (1) comporte au moins deux chambres (7, 8), les deux chambres (7, 8) étant séparées par une paroi (6), les composants (5) se trouvant d'un côté de la paroi, dans une chambre (7), les radiateurs (4) se trouvant de l'autre côté de la paroi (6), dans l'autre chambre (8), et la au moins une réactance et/ou le transformateur (5a) se trouvant dans l'autre chambre (8), cette autre chambre (8) comportant le groupe de refroidissement (2).

2. Onduleur selon la revendication 1,
**caractérisé en ce que**
l'autre chambre (8) comporte des fentes de ventilation (3).

3. Onduleur selon la revendication 2,
**caractérisé en ce que**
les fentes de ventilation (3) sont disposées à l'extrémité qui est à l'opposé du groupe de refroidissement (2), dans l'autre chambre (8).

4. Onduleur selon l'une des revendications précédentes,
**caractérisé en ce que**
l'une des chambres (7) présente un plus haut degré de protection que l'autre chambre (8).

5. Onduleur selon l'une des revendications précédentes,
**caractérisé en ce que**
le groupe de refroidissements (2) est constitué par un ventilateur.

6. Onduleur selon la revendication 1,
**caractérisé en ce que**
la au moins une inductance et/ou le transformateur (5a) se trouvent sur le côté de la paroi (6) qui définit l'autre chambre (8).
